# EUROPEAN PATENT APPLICATION

(11) **EP 4 032 692 A1**
(43) Date of publication of application: **27.07.2022**
(21) Application number: 21193395.7
(22) Date of filing: 26.08.2021
(51) Int. Cl.: B29C 70/38, H05H 1/00, C23C 14/32

(54) **METHOD AND APPARATUS FOR LAYING UP A COMPOSITE MATERIAL ONTO A SUBSTRATE**

(30) Priority: 20.01.2021 US 202163139458 P
(71) Applicant: The Boeing Company, Chicago, IL 60606-2016 (US); United States of America as represented by the Administrator of NASA, Hampton, VA 23681 (US)
(72) Inventor: BELCHER, Marcus Anthony, CHICAGO, 60606 (US)
(74) Representative: Plasseraud IP

(57) **Abstract**

A method for laying up a composite material includes steps of (1) depositing the composite material onto a substrate; (2) compacting the composite material with a compaction roller, the compaction roller and the substrate defining a nip; and (3) projecting a plasma flume proximate the nip to heat at least one of the composite material and the substrate.

## Description

### GOVERNMENT RIGHTS

This invention was made with government support under SAA1-21157; SAA1-21157, Annex 17; and SAA1-21157, Annex 17, MOD 1 awarded by the National Aeronautics and Space Administration. The government has certain rights in this invention. The invention described herein may be manufactured and used by or for the U.S. Government for U.S. Government purposes without the payment of royalties thereon or therefor.

### FIELD

This application relates to manufacturing articles from composite materials and, more particularly, to the laying up of composite materials during such manufacturing and, even more particularly, to the use of plasma heating during the layup of composite materials.

### BACKGROUND

Composite structures are commonly used as high-strength, low-weight materials. A composite structure includes one or more composite layers, wherein each composite layer includes a reinforcement material and a matrix material. The reinforcement material may include fibers. The matrix material may be a polymeric material, such as a thermosetting resin or a thermoplastic resin.

Fiber-reinforced composite structures may be manufactured by laying up multiple layers of fiber tow to form a reinforcement layup. The fiber tow generally includes a bundle of fibers (reinforcement material) impregnated with a matrix material. In fiber placement technologies, the fiber tow is generally supplied as a tape from a bulk reel and is pressed onto the underlying layup at a nip using a compaction roller. The fully assembled reinforcement layup is then cured and/or consolidated, as necessary, to form the composite structure.

When the matrix material of the fiber tow is a thermoplastic resin, the layup process typically requires heating to soften the thermoplastic resin and obtain layer-to-layer consolidation within the reinforcement layup. For example, a laser beam (e.g., an infrared laser beam) may be projected proximate (i.e., at or near) the nip to heat the fiber tow and/or the underlying layup during fiber placement. However, the laser light may not evenly apply heating across parts having complex curvature. Further, lasers typically require additional safety features and are thus cost prohibitive.

Accordingly, those skilled in the art continue with research and development efforts in the field of laying up composite materials.

### SUMMARY

Disclosed a method for laying up a composite material.

In an example, the method for laying up a composite material includes depositing the composite material onto a substrate. The method further includes compacting the composite material with a compaction roller. The compaction roller and the substrate are configured to define a nip. The method further includes projecting a plasma flume proximate the nip to heat at least one of the composite material and the substrate.

Also disclosed is an apparatus for laying up composite material onto a substrate.

In an example, an apparatus for laying up composite material onto a substrate includes a compaction roller. The compaction roller is configured to define a nip when the compaction roller is engaged with the substrate. The apparatus further includes a plasma generating device. The plasma generating device is positioned to project a plasma flume toward the nip.

### BRIEF DESCRIPTION OF THE DRAWINGS

FIG. 1 is a cross-sectional front view of an apparatus for laying up composite material.
FIG. 2 is a cross-sectional front view of an apparatus for laying up composite material.
FIG. 3 is a cross-sectional front view of a plasma generating device.
FIG. 4 is a schematic representation of a plasma generating device.
FIG. 5 is a perspective view of a nozzle tip of the plasma generating device of FIG. 4.
FIG. 6 is a perspective view of a nozzle tip of the plasma generating device of FIG. 4
FIG. 7 is a flowchart illustrating a method for laying up a composite material.
FIG. 8 is a flow diagram of an aircraft manufacturing and service methodology.
FIG. 9 is a block diagram of an aircraft.

### DETAILED DESCRIPTION

The following detailed description refers to the accompanying drawings, which illustrate specific examples described by the disclosure. Other examples having different structures and operations do not depart from the scope of the present disclosure. Like reference numerals may refer to the same feature, element, or component in the different drawings.

Illustrative, non-exhaustive examples, which may be, but are not necessarily, claimed, of the subject matter according the present disclosure are provided below.

The following disclosure refers to methods and accompanying apparatuses utilizing plasma treatment to facilitate tack between layers of composite material. In one or more examples, a layer of composite material is laid down and, subsequently, a layer of composite material is laid on top of the first layer. The tacking maintains the composite material layers in place relative to each other until the layup of composite material is complete and/or hardened.

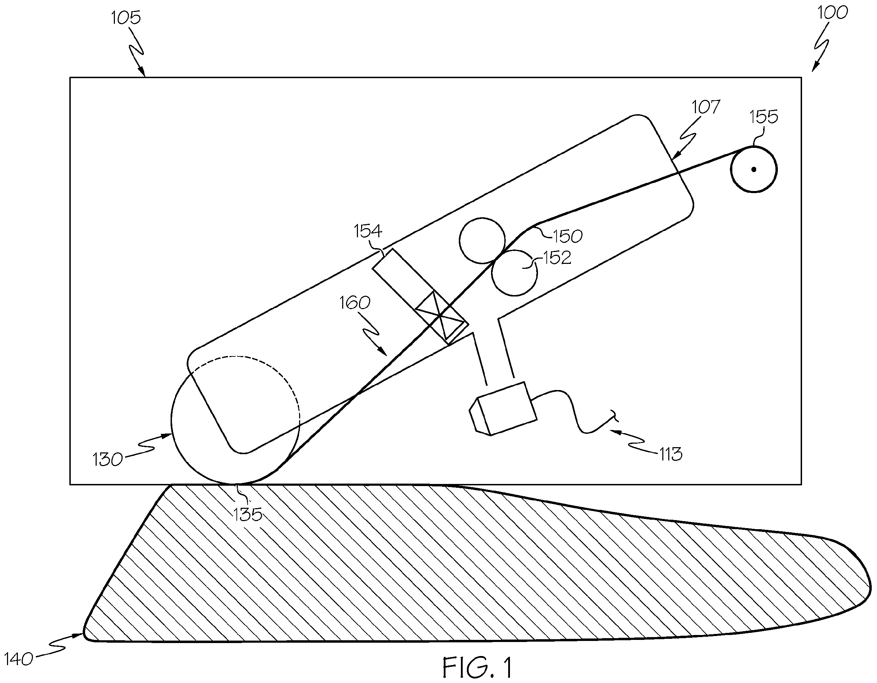

Referring to FIG. 1, an exemplary embodiment of an apparatus 100 for laying up composite material 160 onto a substrate 140 is illustrated. In one or more examples, the apparatus 100 includes a housing 105. In an example, the apparatus 100 further includes a support structure 107 located, at least partially, within the housing 105. In one or more examples, the apparatus further includes a compaction roller 130. In an example, compaction roller 130 is located, at least partially, within the housing 105. The compaction roller 130 is adjustably and rotationally mounted within the apparatus 100. In an example, the compaction roller 130 is adjustably and rotationally mounted to the support structure 107 located within the housing 105 of the apparatus 100. The compaction roller 130 is configured to define a nip 135 when the compaction roller 130 is engaged with the substrate 140. The compaction roller 130 is configured to exert compaction, or placement force, on the composite material 160 to press it against the substrate 140.

In an example, the apparatus 100 includes a heat source 113 configured to heat at least a portion of the composite material 160 or at least a portion of the substrate 140. In an example, the heat source 113 is an electric heater, an infrared heater, a laser, a laser diode array, a hot gas torch, or a plasma generating device 120. In an example, the heat source 113 is positioned such that it is directed to the nip 135. The heat source 113 is configured to treat the composite material 160 at approximately the nip 135. In one or more examples, the heat source 113 is a plasma generating device 120 that provides heat to improve tack and otherwise activate a previous layer of towpreg/prepreg/etc. composite material 160 to improve the layer by layer tack/adhesion/placement of subsequent towpreg/prepreg/etc. layers of composite material 160.

In an example, the apparatus 100 includes a bulk reel 155. In an example, the bulk reel 155 is contained, at least partially, within the housing 105. The bulk reel 155 is adjustably mounted within the apparatus 100. The bulk reel 155 contains the composite material 160 and is configured to feed the composite material 160 from the apparatus 100 to the substrate 140. In an example, the composite material 160 contained within the bulk reel 155 is tape 150. In an example, the apparatus 100 includes a feed unit 152 located adjacent to the bulk reel 155. The feed unit 152 is positioned to move, or feed, the composite material 160 from the bulk reel 155 to the nip 135.

In an example, the apparatus 100 includes a cutting unit 154. Cutting unit 154 is located, at least partially, within the housing 105. The cutting unit 154 may be positioned along the feed unit 152 between the bulk reel 155 and the compaction roller 130 such that the composite material 160 may feed through the bulk reel 155, then through the cutting unit 154, where the composite material 160 may be cut to any desired length. The composite material 160 may then be fed to the substrate 140 where it is compacted, or consolidated, by the compaction roller 130. The compaction roller 130 is configured to apply force to the composite material 160 against the substrate 140 while the composite material 160 is disposed or fed from the bulk reel 155. In an example, the composite material 160 is tape 150. In an example, the composite material 160 includes a reinforcement material. In an example, the composite material 160 includes a thermoplastic material.

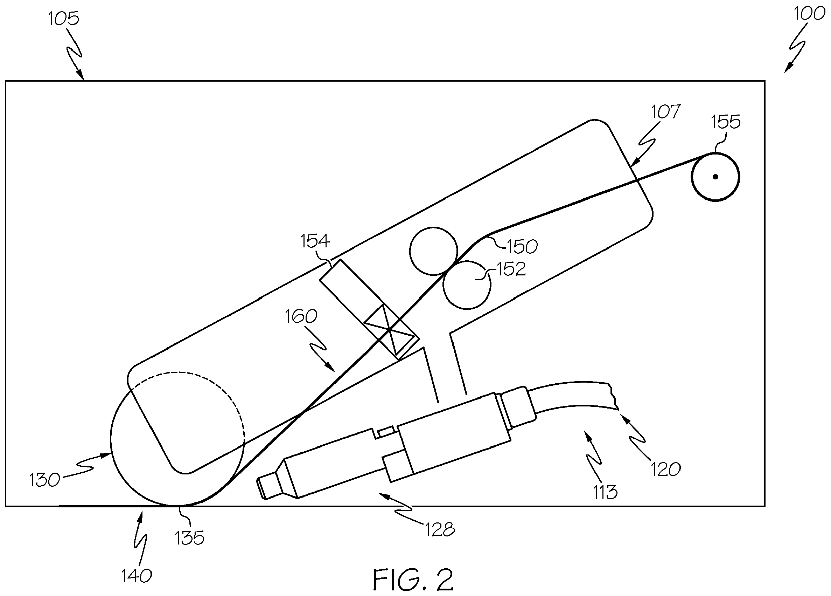

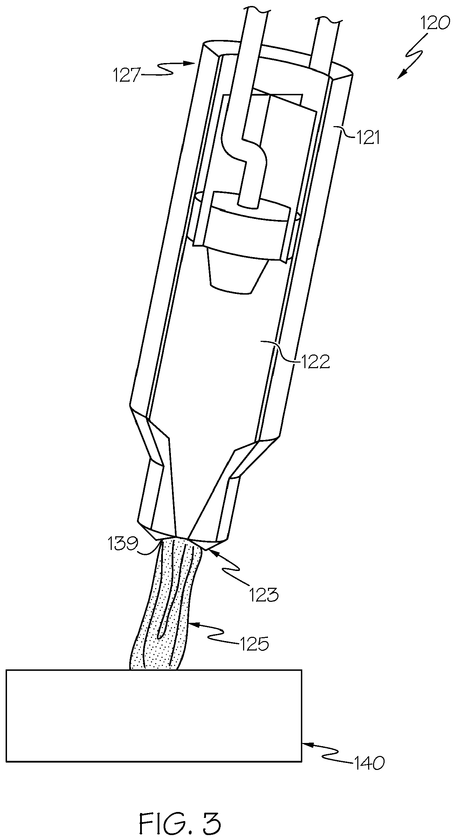

FIG. 2 illustrates an exemplary embodiment of an apparatus 100. In an example, the apparatus 100 includes a housing 105. In an example, the apparatus 100 includes a support structure 107 located, at least partially, within the housing 105. In one or more examples, the apparatus further includes a compaction roller 130. In an example, compaction roller 130 is located, at least partially, within the housing 105. In an example, the compaction roller 130 is adjustably and rotationally mounted to the support structure 107 located within the housing 105 of the apparatus 100. The compaction roller 130 is configured to define a nip 135 when the compaction roller 130 is engaged with the substrate 140. In one or more examples, the apparatus 100 includes a heat source 113 configured to heat at least a portion of the composite material 160 or at least a portion of the substrate 140. In an example, the heat source 113 is a plasma generating device 120. In an example, the plasma generating device 120 is located, at least partially, within the housing 105. The plasma generating device 120 is positioned to project a plasma flume 125, illustrated in FIG. 3, toward the nip 135. In an example, the plasma generating device 120 includes an atmospheric pressure plasma head 128.

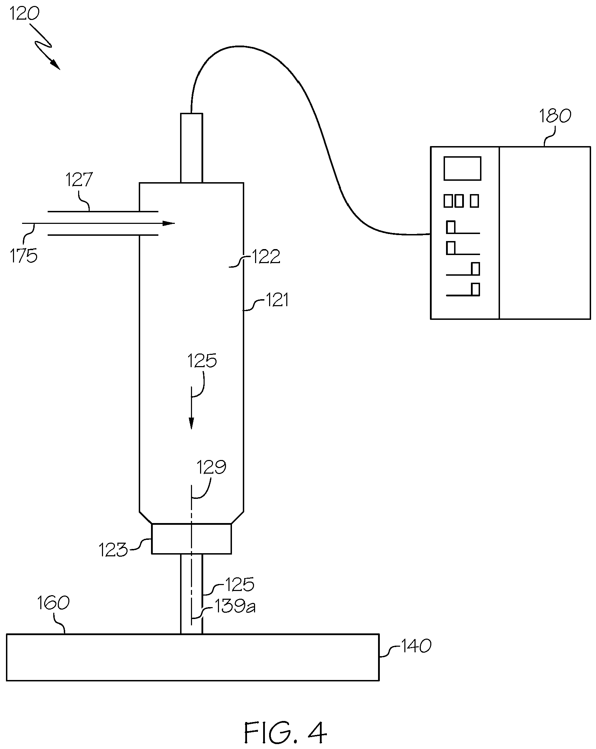

FIG. 3 illustrates a cross-sectional view of an example of a plasma generating device 120. In one or more examples, the plasma generating device 120 includes a nozzle tip 123. The nozzle tip 123 is configured to direct the plasma flume 125 at an emanation angle. In one or more examples, the emanation angle ranges from about 0 degrees to about 15 degrees. In one or more examples, the nozzle tip 123 is configured to direct the plasma flume 125 at an emanation angle of about 0 degrees, meaning the nozzle central axis 129 of the nozzle tip 123 is approximately aligned or parallel with the plasma flume 125 flume aperture central axis 139a, illustrated in FIG. 4, the flume aperture 139 being where the plasma flume 125 emanates from the nozzle tip 123. In one or more examples, the nozzle tip 123 directs the plasma flume 125 at approximately 1.65 ± 0.1 cm from the nip 135. In one or more examples, the nozzle tip 123 is interchangeable such that any desired shape and emanation angle of the plasma flume 125 may be achieved. In one or more examples, the nozzle tip 123 is configured to direct the plasma flume 125 at an emanation angle of about 17 degrees. The plasma flume 125 is configured to treat the composite material 160 to improve layup or tack of the composite material 160 on the substrate 140. Specifically, the plasma flume 125 contains charged species that may modify the surface of the composite material 160 with chemical groups (e.g. oxygen functionality) that enhance material tack and, ultimately, layup of composite material 160. The plasma treatment may increase the surface energy of the surface of the composite material 160, thereby increasing the propensity of the surface for material tack and layup of composite material 160 relative to the surface prior to plasma treatment. The plasma flume 125 is positioned at an emanation angle and at a distance from the composite material 160 to achieve optimum temperature for tacking and consolidation across the entire width of the composite ply or tape 150. In one or more examples, the optimum temperature is approximately 93 °C.

FIG. 4 illustrates an exemplary embodiment of plasma generating device 120. The plasma generating device 120 includes a plasma generator 180 that is connected to plasma jet 121. The plasma jet 121 includes a chamber 122, at least one inlet 127 for compressed gas 175, and a nozzle tip 123. In an example, the compressed gas 175 includes compressed air. In an example, the compressed gas 175 includes ionization gas. The plasma generating device 120 may be operated manually or may be automated, such as with an automated fiber placement (AFP) machine 115. Upon excitation with electrical power from the plasma generator 180, compressed gas 175 within the chamber 122 is ionized to produce the plasma flume 125. The plasma flume 125 is expelled from the chamber 122 and through the nozzle tip 123, and impinges on the composite material 160 on the substrate 140 at approximately the nip 135 for treatment thereof.

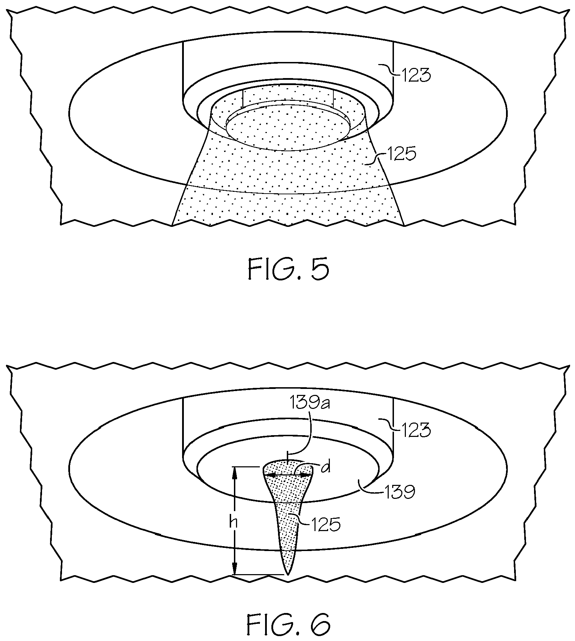

FIG. 5 and FIG. 6 illustrate various nozzle tip 123 configurations. In an example, the emanation angle of the nozzle tip 123 is about 17 degrees (±0.2%) or less, see FIG. 5. This example illustrates configurations used in the past. In an example, the emanation angle of the nozzle tip 123 is about 0 degrees (±0.2%) or less, see FIG. 6. The low emanation angle of the nozzle tip 123 provides a more intense and focused (less diffuse) plasma flume 125 relative to nozzle tips with greater emanation angles. The more intense and focused plasma flume 125 provided with the nozzle tip 123 enhances composite material 160 layup across substrate 140 surfaces at reduced treatment times compared to nozzle tips with higher emanation angles. Even materials that are typically difficult to fabricate due to their low surface energies, such as thermoplastic materials, may exhibit composite material 160 layup enhancements at reduced treatment times using the nozzle tip 123.

Although nozzles having greater emanation angles are generally rotated in order to provide a more diffuse annular plasma flume 125 or plasma "cone" or "ring," a nozzle tip 123 having a zero degree angle is generally not rotated during plasma treatment. Due to the low emanation angle, the nozzle tip 123 having a zero degree angle may provide a more focused and intense plasma flume for impingement on the surface of the composite material 160 on the substrate 140 at a given orientation, such as a normal orientation, as compared to nozzle tips having greater emanation angles. In an example, the diameter (d) of the plasma flume 125 emanating from the nozzle tip 123 having a zero degree angle may be about 6.4 millimeters (±2%), with it being understood that the exterior or outer edge of the plasma flume 125 is fluid and variable in practice. Accordingly, the diameter (d) of the plasma flume 125 disclosed herein is approximate but generally constant as it is generated by the plasma generating device 120. Additionally, the plasma flume 125 may have a height (h) ranging from about 1.2 centimeters to about 2.0 centimeters. As such, the distance between the nozzle tip 123 and the surface of composite material 160 on the substrate 140 during plasma treatment may range from about 1.2 centimeters to about 2.0 centimeters during the plasma treatment process. In contrast, a nozzle tip having a 17 degree angle, which has an emanation angle of 17 degrees and rotates (typically at about 2800 rpm) during plasma treatment, produces an annular flume with a plasma flume 125 diameter of about 24 millimeters at a plume height (the distance from the nozzle tip 123) of about 1.3 centimeters. The nozzle tip 123 having a zero degree angle thus affords a greater working distance than the nozzle tip 123 having a 17 degree angle, and provides a plasma flume 125 that is about four times more focused than the wider (more diffuse) annular plasma flume 125 of the nozzle tip 123 having a 17 degree angle. The greater working distance may facilitate processing of substrates with complex geometries. Depending on the configuration of the nozzle tip 123 having a zero degree angle and/or other factors, the diameter (d) and height (h) of the plasma flume 125 may deviate from the values provided above.

In an example, the composite material 160 on the substrate 140 treated by the plasma generating device 120 is a thermoplastic material. The thermoplastic material may be treated by the plasma generating device 120 to aid in composite material 160 tack. Thermoplastic materials that may exhibit increased composite material 160 layup propensities with plasma treatment in accordance with the present disclosure include, but are not limited to, polyphenylene sulfide, polyaryletherketone (PAEK), polyetherketoneketone (PEKK), polyetheretherketone (PEEK), polyimide, polyetherimide, polyamide, polyamide-imide, polyester, polybutadiene, polyurethane, polypropylene, polysulfone, polyethersulfone, polyphenylsulfone, polyacrylamide, polyketone, polyphthalamide, polyphenylene ether, polybutylene terephthalate, polyethylene, polyethylene terephthalate, polyester-polyarylate (e.g. Vectran^{®}), polytetrafluoroethylene (PTFE), and other thermoplastic resins.

In an example, the composite material 160 on the substrate 140 treated by the plasma generating device 120 is a thermoset material. The thermoset material may be treated by the plasma generating device 120 to aid in composite material 160 tack. Examples of suitable thermoset materials include, but are not limited to, epoxy resins, cyanate esters, benzoxazines, polyimides, bismaleimides, vinyl esters, polyurethanes, polyureas, polyurethane/polyurea blends, polyesters, and other thermoset resins. The composite material 160 on the substrate 140 may be formed from or include other materials such as, but not limited to, metal, ceramic, rubber, glass, and composite materials.

Optionally, the composite material 160 on the substrate 140 may be reinforced with a reinforcing material. Reinforcing materials may include, but are not limited to, carbon fiber, glass fiber, glass spheres, mineral fiber, or other reinforcing materials. If fibers are used as a reinforcing material, the fibers may be continuous or chopped, and may be unidirectional, randomly-oriented, or in the form of a weave such as, but not limited to, a plain weave, a crowfoot weave, a basket weave, and a twill weave.

The intense plasma flume 125 generated by the nozzle tip 123 having a zero degree angle may substantially reduce plasma treatment times needed for increasing composite material 160 layup and material tack propensities compared to a nozzle tip 123 having emanation angles greater than 5 degrees. In an example, the layup of composite material 160 includes adhesion to like material. In an example, the layup of composite material 160 includes adhesion with other materials including prepreg material.

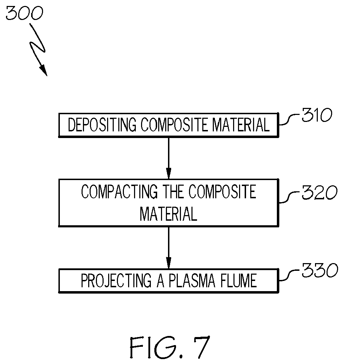

FIG. 7 illustrates a flowchart of a method 300 for laying up a composite material 160. In an example, the method 300 includes depositing 310 a composite material 160 onto a substrate 140. In an example, the substrate 140 is a tool 145. In an example, the substrate 140 is a previously-applied composite material 160 on a tool 145. Composite material 160 may be in the form of a composite ply or a tape 150. In an example, the composite material 160 includes a reinforcement material. In an example, the composite material 160 includes a thermoplastic material. Thermoplastic materials that may exhibit increased composite material 160 layup and material tack propensities with plasma treatment in accordance with the present disclosure include, but are not limited to, polyphenylene sulfide, polyaryletherketone (PAEK), polyetherketoneketone (PEKK), polyetheretherketone (PEEK), polyimide, polyetherimide, polyamide, polyamide-imide, polyester, polybutadiene, polyurethane, polypropylene, polysulfone, polyethersulfone, polyphenylsulfone, polyacrylamide, polyketone, polyphthalamide, polyphenylene ether, polybutylene terephthalate, polyethylene, polyethylene terephthalate, polyester-polyarylate (e.g. Vectran^{®}), polytetrafluoroethylene (PTFE), and other thermoplastic resins.

In an example, the composite material 160 on the substrate 140 treated by the plasma generating device 120 of the method 300 is a thermoset material. Examples of suitable thermoset materials include, but are not limited to, epoxy resins, cyanate esters, benzoxazines, polyimides, bismaleimides, vinyl esters, polyurethanes, polyureas, polyurethane/polyurea blends, polyesters, and other thermoset resins. The composite material 160 on the substrate 140 may be formed from or include other materials such as, but not limited to, metal, ceramic, rubber, glass, and composite materials.

In an example, the depositing 310 includes receiving composite material 160 from a bulk reel 155. In an example, the bulk reel 155 is contained, at least partially, within the housing 105. The bulk reel 155 is adjustably mounted within the apparatus 100. The bulk reel 155 contains the composite material 160 and is configured to feed the composite material 160 from the apparatus 100 to where it is deposited on the substrate 140. In an example, the composite material 160 contained within the bulk reel 155 is tape 150. In an example, the apparatus 100 includes a feed unit 152 located adjacent to the bulk reel 155. The feed unit 152 is positioned to move, or feed, the composite material 160 from the bulk reel 155 to the nip 135 at the substrate 140.

In an example, the depositing 310 includes cutting the composite material 160 with a cutting unit 154. Cutting unit 154 is located, at least partially, within the housing 105. The cutting unit 154 may be positioned along the feed unit 152 between the bulk reel 155 and compaction roller 130 such that the composite material 160 may feed through the bulk reel 155, then through the cutting unit 154, where the composite material 160 may be cut to any desired length. The composite material 160 may then be deposited onto the substrate 140 where it is compacted, or consolidated, by the compaction roller 130, as described below.

In an example, the method 300 includes compacting 320 the composite material 160 with a compaction roller 130. The compaction roller 130 and the substrate 140 are configured to define a nip 135. In an example, compaction roller 130 is located, at least partially, within a housing 105 of an apparatus 100. The compaction roller 130 is adjustably and rotationally mounted within the apparatus 100. In an example, the compaction roller 130 is adjustably and rotationally mounted to a support structure 107 located within the housing 105 of the apparatus 100. The compaction roller 130 is configured to define the nip 135 when the compaction roller 130 is engaged with the substrate 140. The compaction roller 130 is configured to exert compaction or placement force on the composite material 160 to press it against the substrate 140 when compacting 320 the composite material 160 on the substrate 140.

In an example, the method 300 includes projecting 330 a plasma flume 125 proximate the nip 135 to heat at least one of the composite material 160 and the substrate 140. In an example, the projecting 330 the plasma flume 125 of the method 300 includes projecting 330 the plasma flume 125 from a plasma generating device 120. In an example, the plasma generating device 120 includes an atmospheric pressure plasma head 128. In an example, the projection 330 the plasma flume 125 includes projecting the plasma flume 125 at a pressure ranging from about 15 psi to about 50 psi.

In an example, the projecting 330 the plasma flume 125 of the method 300 includes projecting the plasma flume 125 at an emanation angle, ranging from about 0 degrees to about 20 degrees. In an example, the projecting 330 the plasma flume 125 of the method 300 includes projecting the plasma flume 125 at an emanation angle, ranging from about 0 degrees to about 10 degrees. In an example, the projecting 330 the plasma flume 125 of the method 300 includes projecting the plasma flume 125 at an emanation angle, ranging from about 0 degrees to about 5 degrees. In an example, the projecting 330 the plasma flume 125 of the method 300 includes projecting the plasma flume 125 at an emanation angle of approximately zero degrees.

In an example, the plasma flume 125 of the method 300 has a maximum width of about 3.5 millimeters to about 9 millimeters. In an example, the plasma flume 125 has a length of about 1.25 centimeters to about 3 centimeters. In an example, the plasma flume 125 is about 1.25 centimeters to about 2 centimeters from the nip 135. The shape of the nozzle tip 123 facilitates the shape and size of the plasma flume 125. In an example, the diameter (d) of the plasma flume 125 emanating from the nozzle tip 123 having a zero degree angle may be about 6.5 millimeters (±2%), with it being understood that the exterior or outer edge of the plasma flume 125 is fluid and variable in practice. Accordingly, the diameter (d) of the plasma flume 125 disclosed herein is approximate but generally constant as it is generated by the plasma generating device 120. Additionally, the plasma flume 125 may have a height (h) ranging from about 1.2 centimeters to about 2.0 centimeters. As such, the distance between the nozzle tip 123 and the surface of composite material 160 on the substrate 140 during plasma treatment may range from about 1.2 centimeters to about 2.0 centimeters during the plasma treatment process. In contrast, a nozzle tip having a 17 degree angle, which has an emanation angle of 17 degrees and rotates (typically at about 2800 rpm) during plasma treatment, produces an annular flume with a plasma flume 125 diameter of about 24 millimeters and a height of about 1.3 centimeters. The nozzle tip 123 having a zero degree angle thus affords a greater working distance than the nozzle tip 123 having a 17 degree angle, and provides a plasma flume 125 that is about four times more focused than the wider (more diffuse) annular plasma flume 125 of the nozzle tip 123 having a 17 degree angle. The greater working distance may facilitate processing of substrates with complex geometries. Depending on the configuration of the nozzle tip 123 having a zero degree angle and/or other factors, the diameter (d) and height (h) of the plasma flume 125 may deviate from the values provided above.

The following examples are non-limiting and only illustrate exemplary implementations of the invention.

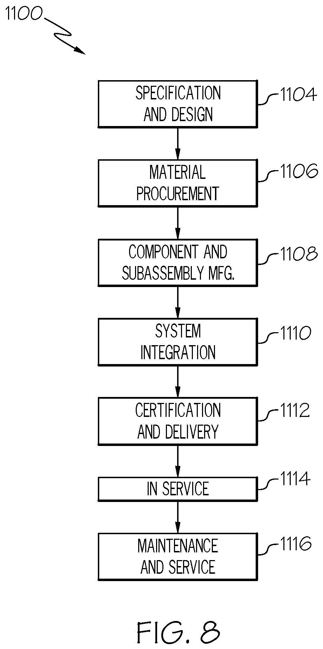

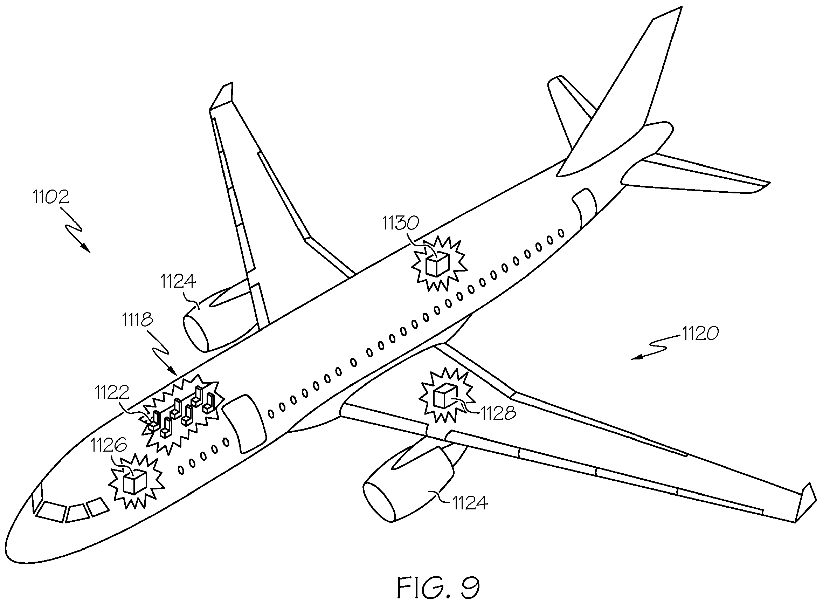

Examples of the disclosure may be described in the context of an aircraft manufacturing and service method 1100, as shown in FIG. 8, and an aircraft 1102, as shown in FIG. 9. During pre-production, the aircraft manufacturing and service method 1100 may include specification and design 1104 of the aircraft 1102 and material procurement 1106. During production, component/subassembly manufacturing 1108 and system integration 1110 of the aircraft 1102 takes place. Thereafter, the aircraft 1102 may go through certification and delivery 1112 in order to be placed in service 1114. While in service by a customer, the aircraft 1102 is scheduled for routine maintenance and service 1116, which may also include modification, reconfiguration, refurbishment and the like.

Each of the steps of method 1100 may be performed or carried out by a system integrator, a third party, and/or an operator 500 (e.g., a customer). For the purposes of this description, a system integrator may include without limitation any number of aircraft manufacturers and major-system subcontractors; a third party may include without limitation any number of venders, subcontractors, and suppliers; and an operator 500 may be an airline, leasing company, military entity, service organization, and so on.

As shown in FIG. 9, the aircraft 1102 produced by example method 1100 may include an airframe 1118 with a plurality of systems 1120 and an interior 1122. Examples of the plurality of systems 1120 may include one or more of a propulsion system 1124, an electrical system 1126, a hydraulic system 1128, and an environmental system 1130. Any number of other systems may be included.

The disclosed methods and systems may be employed during any one or more of the stages of the aircraft manufacturing and service method 1100. As one example, components or subassemblies corresponding to component/subassembly manufacturing 1108, system integration 1110 and/or maintenance and service 1116 may be assembled using the disclosed methods and systems. As another example, the airframe 1118 may be constructed using the disclosed methods and systems. Also, one or more apparatus examples, method examples, or a combination thereof may be utilized during component/subassembly manufacturing 1108 and/or system integration 1110, for example, by substantially expediting assembly of or reducing the cost of an aircraft 1102, such as the airframe 1118 and/or the interior 1122. Similarly, one or more of system examples, method examples, or a combination thereof may be utilized while the aircraft 1102 is in service, for example and without limitation, to maintenance and service 1116.

Aspects of disclosed examples may be implemented in software, hardware, firmware, or a combination thereof. The various elements of the system, either individually or in combination, may be implemented as a computer program product tangibly embodied in a machine-readable storage device for execution by a processor. Various steps of examples may be performed by a computer processor executing a program tangibly embodied on a computer-readable medium to perform functions by operating on input and generating output. The computer-readable medium may be, for example, a memory, a transportable medium such as a compact disk or a flash drive, such that a computer program embodying aspects of the disclosed examples can be loaded onto a computer.

The above-described methods and systems are described in the context of an aircraft. However, one of ordinary skill in the art will readily recognize that the disclosed methods and systems are suitable for a variety of applications, and the present disclosure is not limited to aircraft manufacturing applications. For example, the disclosed methods and systems may be implemented in various articles of manufacture not limited to aircraft or aircraft components and the like. Non-aircraft applications are also contemplated.

Also, although the above-description describes methods and systems that may be used to manufacture an aircraft or aircraft component in the aviation industry in accordance with various regulations (e.g., commercial, military, etc.), it is contemplated that the disclosed methods and systems may be implemented to facilitate manufacturing of a part in any industry in accordance with the applicable industry standards. The specific methods and systems can be selected and tailored depending upon the particular application.

The disclosure includes example embodiments in accordance with the following numbered examples:
Example 1. A method for laying up a composite material, the method comprising:
   depositing (310) the composite material (160) onto a substrate (140);
   compacting (320) the composite material (160) with a compaction roller (130), the compaction roller (130) and the substrate (140) defining a nip (135); and
   projecting (330) a plasma flume (125) proximate the nip (135) to heat at least one of the composite material (160) and the substrate (140).
Example 2. The method (300) of Example 1, wherein the composite material (160) is a tape (150).
Example 3. The method (300) of Example 1 or 2, wherein the composite material (160) comprises a reinforcement material.
Example 4. The method (300) of any of Examples 1-3, wherein the composite material (160) further comprises a thermoplastic material.
Example 5. The method (300) of any of Examples 1-4, wherein projecting (330) the plasma flume (125) comprises projecting the plasma flume (125) from a plasma generating device (120), and wherein the plasma generating device (120) comprises an atmospheric pressure plasma head (128).
Example 6. The method (300) of any of Examples 1-5, wherein projecting (330) the plasma flume (125) comprises projecting the plasma flume (125) at an emanation angle ranging from about 0 degrees to about 20 degrees.
Example 7. The method (300) of any of Examples 1-6, wherein projecting (330) the plasma flume (125) comprises projecting the plasma flume (125) at an emanation angle ranging from about 0 degrees to about 10 degrees.
Example 8. The method (300) of any of Examples 1-7, wherein projecting (330) the plasma flume (125) comprises projecting the plasma flume (125) at an emanation angle ranging from about 0 degrees to about 5 degrees.
Example 9. The method (300) of any of Examples 1-8, wherein projecting (330) the plasma flume (125) comprises projecting the plasma flume (125) at a pressure ranging from about 15 psi to about 50 psi.
Example 10. The method (300) of any of Examples 1-9, wherein the plasma flume (125) has a maximum width of about 3.8 millimeters to about 8.9 millimeters.
Example 11. The method (300) of any of Examples 1-10, wherein the plasma flume (125) has a length of about 1.2 centimeters to about 2.6 centimeters.
Example 12. The method (300) of any of Examples 1-11, wherein the substrate (140) is a tool (145).
Example 13. The method (300) of any of Examples 1-12, wherein the substrate (140) is a previously-applied composite material (160) on a tool (145).
Example 14. The method (300) of any of Examples 1-13, wherein the plasma flume (125) is about 1.2 centimeters to about 2 centimeters from the nip (135).
Example 15. An apparatus (100) for laying up composite material (160) onto a substrate (140), the apparatus (100) comprising:
   a compaction roller (130), the compaction roller (130) being configured to define a nip (135) when the compaction roller (130) is engaged with the substrate (140); and
   a plasma generating device (120) positioned to project a plasma flume (125) toward the nip (135).
   Example 16. The apparatus (100) of Example 15, wherein the plasma generating device (120) comprises an atmospheric pressure plasma head (128).
   Example 17. The apparatus (100) of Example 15 or 16, wherein the plasma generating device (120) comprises a nozzle tip (123) configured to direct the plasma flume (125) at an emanation angle ranging from about 0 degrees to about 15 degrees.
   Example 18. The apparatus (100) of any of Examples 15-17, further comprising a bulk reel (155) containing the composite material (160).
   Example 19. The apparatus (100) of any of Examples 15-18, wherein the composite material (160) comprises a reinforcement material.
   Example 20. The apparatus (100) any of Examples 15-19, wherein the composite material (160) further comprises a thermoplastic material.
   Example 21. The apparatus (100) any of Examples 15-18, wherein the bulk reel (155) is located, at least partially, within the housing (105).
   Example 22. The apparatus (100) any of Examples 15-18, further comprising a feed unit (152) positioned to move the composite material (160) from the bulk reel (155) to the nip (135).
   Example 23. The apparatus (100) any of Examples 15-22, wherein the composite material (160) is a tape (150).
   Example 24. The apparatus (100) of any of Examples 15-23, further comprising a cutting unit (154) located, at least partially, within the housing (105).
   Example 25. An automated fiber placement machine (115), comprising the apparatus (100) of any of Examples 15-24.

The described features, advantages, and characteristics of one example may be combined in any suitable manner in one or more other examples. One skilled in the relevant art will recognize that the examples described herein may be practiced without one or more of the specific features or advantages of a particular example. In other instances, additional features and advantages may be recognized in certain examples that may not be present in all examples. Furthermore, although various examples of the manufacturing system, the process, and the method have been shown and described, modifications may occur to those skilled in the art upon reading the specification. The present application includes such modifications and is limited only by the scope of the claims.

## Claims

1. A method for laying up a composite material comprising:
depositing (310) the composite material (160) onto a substrate (140);
compacting (320) the composite material (160) with a compaction roller (130), the compaction roller (130) and the substrate (140) defining a nip (135); and
projecting (330) a plasma flume (125) proximate the nip (135) to heat at least one of the composite material (160) and the substrate (140).

2. The method (300) of Claim 1, wherein the composite material (160) is a tape (150).

3. The method (300) of Claim 1 or 2, wherein the composite material (160) comprises a reinforcement material.

4. The method (300) of any of Claims 1-3, wherein projecting (330) the plasma flume (125) comprises projecting the plasma flume (125) from a plasma generating device (120), and wherein the plasma generating device (120) comprises an atmospheric pressure plasma head (128).

5. The method (300) of any of claims 1-4, wherein projecting (330) the plasma flume (125) comprises projecting the plasma flume (125) at an emanation angle ranging from about 0 degrees to about 20 degrees.

6. The method (300) of any of Claims 1-5, wherein projecting (330) the plasma flume (125) comprises projecting the plasma flume (125) at a pressure ranging from about 15 psi to about 50 psi.

7. An apparatus (100) for laying up composite material (160) onto a substrate (140), the apparatus (100) comprising:
a compaction roller (130), the compaction roller (130) being configured to define a nip (135) when the compaction roller (130) is engaged with the substrate (140); and
a plasma generating device (120) positioned to project a plasma flume (125) toward the nip (135).

8. The apparatus (100) of Claim 7, wherein the plasma generating device (120) comprises an atmospheric pressure plasma head (128).

9. The apparatus (100) of Claim 7 or 8, wherein the plasma generating device (120) comprises a nozzle tip (123) configured to direct the plasma flume (125) at an emanation angle ranging from about 0 degrees to about 15 degrees.

10. The apparatus (100) of any of Claims 7-9, further comprising a bulk reel (155) containing the composite material (160).

11. The apparatus (100) of Claim 10, wherein the composite material (160) comprises a reinforcement material.

12. The apparatus (100) of Claim 11, wherein the composite material (160) further comprises a thermoplastic material.

13. The apparatus (100) of any of Claims 10-12, wherein the bulk reel (155) is located, at least partially, within the housing (105).

14. The apparatus (100) of any of Claims 10-13, further comprising a feed unit (152) positioned to move the composite material (160) from the bulk reel (155) to the nip (135).

15. An automated fiber placement machine (115) comprising the apparatus (100) of any of Claims 10-14.
